# EUROPEAN PATENT APPLICATION

(11) **EP 4 269 111 A1**
(43) Date of publication of application: **01.11.2023**
(21) Application number: 21914077.9
(22) Date of filing: 22.12.2021
(51) Int. Cl.: B41C 1/00

(54) **FLAT-TOP DOT FLEXIBLE RESIN PLATE WITH TEXTURE ON SURFACE THEREOF, AND PLATE-MAKING METHOD THEREFOR**

(30) Priority: 28.12.2020 CN 202011573670
(71) Applicant: Lucky Huaguang Printing Technology Co., Ltd., Nanyang, Henan 473003 (CN)
(72) Inventor: GAO, Yingxin, Nanyang, Henan 473003 (CN); WANG, Xiaoyang, Nanyang, Henan 473003 (CN); HUANG, Yongshan, Nanyang, Henan 473003 (CN); LIU, Bin, Nanyang, Henan 473003 (CN); FAN, Zhonghui, Nanyang, Henan 473003 (CN); XU, Wenran, Nanyang, Henan 473003 (CN); WANG, Guocai, Nanyang, Henan 473003 (CN); LI, Zhiyong, Nanyang, Henan 473003 (CN); WANG, Xiangli, Nanyang, Henan 473003 (CN)
(74) Representative: Ipside
(86) International application number: PCT/CN2021/140463
(87) International publication number: WO 2022/143340

(57) **Abstract**

A flat-top dot flexographic resin plate with a texture on the surface thereof and a plate-making method therefor. The structure of the flexographic resin plate from top to bottom successively comprises a laser-ablated black film layer, an oxygen blocking layer, a rough surface layer with particles, a photosensitive elastomer layer, a bonding layer, and a supporter; the particles in the rough surface layer are organic polymer particles, the average diameter of which is 0.5-15 µm; when the rough surface layer with the organic polymer particles is laminated together with the photosensitive elastomer layer, grains formed by the organic polymer particles are transferred to the surface of the photosensitive elastomer, forming a texture and improving the ink transfer performance of the flexographic resin plate. The flexographic resin plate is provided with an oxygen blocking layer to reduce the impact of oxygen on the polymerization of the photosensitive elastomer, which can form flat-top dots and improve the press run of the plate material.

## Description

### Technical Field

The present invention relates to a method for preparing a flexographic resin plate, in particular a flat-top dot flexographic resin plate with a texture on the surface thereof and a plate-making method therefor.

### Background Art

Currently, flexographic resin plates are widely used for printing easily deformed or softer printing stocks such as cartons, flexible packages, labels.

Generally, a film with patterns or characters is placed on an unexposed flexographic plate containing a photosensitive elastomer and exposed to ultraviolet rays, with transparent region of the film being transmitted through by ultraviolet light, and an initiator in the photosensitive elastomer being decomposed into free radicals to initiate a reaction of the crosslinkable monomer for curing. In the region with ultraviolet light not transmitted, no cross-linking reaction can occur; thus a relief image containing characters and patterns is obtained by washing and development due to the difference in solubility of the regions in a developer. The developed plate material is subjected to drying, detackification and post-exposure to ensure the complete polymerization of the photosensitive layer. The prepared plate material is fixed on a roller of a flexo printing machine for printing.

This plate-making process needs films with patterns or characters. However, the film is easily influenced by external conditions such as washing processing, dust, humidity, etc., resulting in disadvantages, and thus influencing the reduction of characters, patterns, etc., of the flexographic resin plate material. Meanwhile, when a film is attached on an anti-sticking layer of the flexographic plate, the film is easily sticked, plate-making defects such as light refraction, scattering, etc., are caused, resulting in the reduction of the reproduction quality of patterns or characters.

With the development of the computer technology and the prepress document processing technology, document information with patterns or characters, etc., may be converted into digital information. The digital information is converted into infrared laser, violet laser, etc., to be output to an ablated black film of a flexographic plate by means of computer control, so as to realize the laser ablation imaging with film imaging not being used any longer, such that the problem that the reduced quality of reproduction of plate material patterns or characters caused by plate-making using a film is solved. Such plate materials are referred to as digital flexographic resin plates.

With regard to conventional digital flexographic plates, the protective film is removed, the black film is ablated by laser for imaging, then the photosensitive elastomer is exposed by the UV-A or UV-LED, and the plate is washed by a developer, dried, and subjected to a post treatment to prepare a printing plate. Since the exposure process is performed in the air, the surface of the exposed photosensitive elastomer is inhibited by oxygen in the air, and the reproduced dots of the plate material are in the shape of bullet heads. The bullet-head dots have a small supporting force during printing and a large friction force with the net wall of an anilox roller, such that the press run is not high, the high-light dot printing has a unclear effect, and the printing effect of high-definition flexo printing 150 lpi can not be achieved.

It is found by the researches that to realize the high-definition flexo printing, flat-top dots are needed, and meanwhile the photosensitive elastomer layer needs to be provided with a texture, so as to improve the ink transfer and the press run of the plate material.

In order to realize texturing on the surface of the flexographic resin plate and the flat-top dots, researchers find various solutions.

In a first solution, a light shield in an exposure machine is filled with nitrogen which is provided by a nitrogen making machine or a nitrogen cylinder outside the machine. When the nitrogen reaches a certain concentration, a conventional plate material is exposed, with flat-top dots formed. Patent US 2009/0186308 A1 describes that the oxygen concentration in the exposure machine is preferably 100-190 ppm. This method requires an additional nitrogen making apparatus which is bulky. Besides, it is not easy for nitrogen to keep constant during each plate-making. Therefore, it is not a good method for forming flat-top dots.

In a second solution involving film covering technology, after a black film is engraved and ablated by a conventional laser, a layer of film is covered to block oxygen in the air, followed by front-exposure to form flat-top dots. U.S. Patent US 2017/0297358 A1 optimizes the exposure parameters of film covering to form flat-top dots and the reproduction of the dots is suitable for printing on corrugated carton. The patent includes a procedure additionally added, which is cumbersome to operate by a plate-making corporation, with dust entry or bubble generation during the film covering, resulting in a waste plate.

in a third solution, a plate material with a black film engraved and ablated by laser is immersed in water for exposure to block oxygen in the air, forming flat-top dots as described in patent CN 107521214 A. This patent is cumbersome to use.

In a fourth solution, an oxygen blocking layer is arranged between a laser-ablated black film and a photosensitive elastomer. For example, in patent CN 107969149 A, a plate material has a structure of five layers: (A), (B), (C), (D) and (E). An oxygen blocking layer (C) is arranged between (B) and (D), and has from 50%-99% by weight of polyvinyl acetate or polyvinyl acetal with a molar hydrolysis degree of 10%-75%, 1 %-30% of an alkaline polymer such as polyethyleneimine, and 0-50% of a filler of SiO₂ or silicate. In the patent, the oxygen blocking layer and the SiO₂ or silicate particles within the layer are pressed onto the surface of a flexographic resin plate to form a flat-top dot plate material with a texture. The layer contains SiO₂ or silicate with an average particle size of 2-6 microns, but no organic particles.

The oxygen blocking layer of US 8492074 B2 comprises two different resins, such as polyvinylpyrrolidone, violet lacquer, polyvinyl butyral, polyvinylidene chloride or vinyl chloride polymers, may form flat-top dots, but does not form the surface texture of the plate material.

In a fifth solution, the chemical composition of a photosensitive elastomer is changed to form flat-top dots, but a texture cannot be formed on the surface thereof, as shown in patent US 8808968.

### Summary of the Invention

In order to solve the above problems, the present invention provides a flat-top dot flexographic resin plate with a texture on the surface thereof and a plate-making method therefor. On the surface of a plate material a texture can be formed and flat-top dots are formed so as to improve the ink transfer capacity of the plate material as well as the press run of the plate material.

The objective of the present invention is achieved by using the following method. A flat-top dot flexographic resin plate with a texture on the surface thereof structurally successively from top to bottom comprises a laser-ablated black film layer, an oxygen blocking layer, a rough surface layer with particles, a photosensitive elastomer layer, a bonding layer, and a supporter. The particles in the rough surface layer are organic polymer particles with an average diameter of 0.5-15 µm. When the rough surface layer with the organic polymer particles is laminated together with the photosensitive elastomer layer, grains formed by the organic polymer particles are transferred to the surface of the photosensitive elastomer, forming a texture and improving the ink transfer performance of the flexographic resin plate. The oxygen blocking layer arranged in the present invention reduces the influence of oxygen on polymerization of the photosensitive elastomer, such that flat-top dots are formed.

A protective film layer formed from a protective film may further be arranged on the laser-ablated black film layer for protection. The protective film may be a film made of a high polymer material such as polyhexylene naphthalene-2,6-dicarbonate, polyethylene terephthalate (PET), polybutylene terephthalate (PBT), PE, PVC, etc., preferably a PET film, with a thickness of 50-150 µm, preferably 100-135 µm.

The laser-ablated black film layer may be a laser-ablated black film commonly used in the art and may also be prepared according to the preparation method of patent ZL201110437989.9. The ablated black film contains nano carbon black, a first polymer polyamide adhesive, a second polymer adhesive of a monoisocyanate-modified polyether polyurethane compound, a laser-ablated dye, a super dispersant, a leveling agent, a defoaming agent, etc., an ablated black film solution is prepared, by coating the components onto a supporter PET or PE by means of blade coating, bar coating, anilox roller coating, etc., and dried by hot air, steam, infrared rays, microwave, etc., to form a film for later use, wherein the coating has a thickness of 1-5 µm, preferably 2-4 µm. In order to protect the ablated black film from scratching, the ablated black film obtained by coating may also be coated with other materials such as PE or PET with a thickness of 8-20 µm for later use.

The oxygen blocking layer of the present invention contains polyamide and an acrylic resin containing acrylamide and a derivative thereof. The acrylic resin containing acrylamide and a derivative thereof is at least one of a poly(acrylamide-styrene-methyl methacrylate)resin, a poly(N-hydroxymethyl acrylamide-styrene-methyl methacrylate)resin, a poly(N-hydroxyethyl acrylamide-styrene-methyl methacrylate)resin, a poly(N-hydroxypropyl acrylamide-styrene-methyl methacrylate)resin, polyvinyl pyrrolidone, polyvinyl alcohol, arabic gum, and a polyvinyl butyral resin. A leveling agent, an antifoaming agent, etc., are added to the oxygen blocking layer as necessary. The oxygen blocking layer of the present invention is preferably a mixture of polyamide and an acrylic resin containing acrylamide and a derivative thereof. When laser acts on a laser-ablated black film layer, a spike-wave temperature as high as about 1,000°C may be generated to damage the oxygen blocking layer of the present invention, and has cracks occurred or oxygen blocking layer heated, resulting in a nonuniform thickness. In order to solve the problems, a halogen-free flame retardant or a fire retardant needs to be added into the oxygen blocking layer, such as DAIGUARD-850, DAIGUARD-880, DAIGUARD-540 and DAIGUARD-580 from Japan Daihachi corporation, a fire retardant of FCX-21 0 from Teijin corporation, and an FB-BN880 halogen-free flame retardant from Kaiping Deli corporation. The components are coated onto a laser-ablated black film layer by blade coating, bar coating, anilox roller coating, etc., and dried by hot air, steam, infrared rays, microwave, etc., to form a film for later use, wherein the coating has a thickness of 1-5 µm, preferably 1-3 µm. In order to protect the oxygen blocking layer, the oxygen blocking layer obtained from coating may also be coated with other materials such as PE or PET with a thickness of 8-20 µm for later use.

In the rough surface layer with particles in the present invention, the organic polymer particles in the rough surface layer may be polymethyl methacrylate, polystyrene, dispersed particles, a vinylidene chloride-methyl methacrylate-acrylic acid polymer emulsion, a vinylidene chloride-styrene-methyl methacrylate-acrylic acid polymer emulsion, a styrene-acrylonitrile-methacrylate polyglycol ether copolymer, styrene-acrylonitrile-methacrylic acid polypropylene glycol ether ester copolymer particles, polyvinyl chloride particles, etc. The organic polymer particles in the rough surface layer may be dispersed in water, a polyvinyl alcohol solution, a polymethacrylate-gelatin ethylene-vinyl acetate copolymer emulsion, a polyvinyl pyrrolidone solution, a gelatin solution, or an arabic gum solution, etc. A polymethyl methacrylate-water dispersion system, a polymethacrylate-gelatin dispersion system, and a polymethacrylate-polyvinyl alcohol dispersion system are preferred. Herein, the vinylidene chloride-methyl methacrylate-acrylic acid polymer emulsion is a vinylidene chloride-methyl methacrylate-acrylic acid copolymer, and the vinylidene chloride-styrene-methyl methacrylate-acrylic acid polymer emulsion is a vinylidene chloride-styrene-methyl methacrylate-acrylic acid copolymer.

The organic polymer particles in the rough surface layer of the present invention have an average diameter of 0.5-15 µm, preferably an average particle size of 0.5-10 µm, more preferably an average particle size of 0.5-8 µm. The organic polymer particles may be coated onto the oxygen blocking layer of the present invention by coating, high-pressure air gun spraying, electrostatic spraying, etc. Drying is performed by steam, hot air, infrared electric heating, microwave, etc., at a temperature of 100-140°C for a time of 1-3 minutes. The organic polymer particles are formed into a hemispherical shape, an oval shape, etc., to cover the surface of the oxygen blocking layer of the present invention by processes of pressure and temperature melting, softening, etc. When the rough surface layer with particles of the present invention is covered onto a photosensitive elastomer layer, a texture is formed on the surface of the photosensitive elastomer.

The photosensitive elastomer layer used in the flexographic resin plate of the present invention at least comprises a thermoplastic polymer material, at least one vinyl unsaturated compound, at least one initiator or initiation system, at least one dye, other auxiliary agents, etc.

The thermoplastic polymer material in the photosensitive elastomer layer may be a butadiene/styrene copolymer, an isoprene/styrene copolymer, an acrylonitrile/styrene copolymer, an acrylonitrile/butadiene/styrene copolymer, polyurethane, polyethylene, etc., such as a polystyrene-polybutadiene-polystyrene triblock copolymer, a polystyrene-polyisoprene-polystyrene triblock copolymer, a polystyrene-polyvinylbutylene-polystyrene block copolymer, a polystyrene-polyisoprene star copolymer, an acrylonitrile/butadiene/styrene copolymers, etc.

A vinyl unsaturated compound in the photosensitive elastomer layer may be a monomer such as 2-(2 ethoxy)ethyl acrylate, isoborneol acrylate, 2-phenoxyethyl acrylate, tetrahydrofurfuryl acrylate, 2-hydroxyethyl (meth)acrylate, 2-hydroxyethyl acrylate, hydroxypropyl (meth)acrylate, butyl acrylate, octyl (meth)acrylate, dodecyl (meth)acrylate, stearyl (meth)acrylate, 1,3-propanediol di(meth)acrylate, 1,4-butanediol di(meth)acrylate, 1,5-pentanediol di(meth)acrylate, 1,6-hexanediol di(meth)acrylate, 1,9-nonanediol di(meth)acrylate, triethylene glycol di(meth)acrylate, tetraethylene glycol di(meth)acrylate, pentaethylene glycol di(meth)acrylate, dipropylene glycol diacrylate, tripropylene glycol di(meth)acrylate, tetrapropylene glycol di(meth)acrylate, neopentyl glycol diacrylate, diethylene glycol diacrylate phthalate, tripropylene glycol diacrylate phthalate, ethoxylated bisphenol A diacrylate, ethoxylated trimethylolpropane triacrylate, propoxylated glycerol triacrylate, 2,2-di(p-hydroxyphenyl)-propane di(meth)acrylate, dimethylolpropane di(meth)acrylate, trimethylolpropane tri(meth)acrylate, pentaerythritol di(meth)acrylate, pentaerythritol tri(meth)acrylate, pentaerythritol tetra(meth)acrylate, dipentaerythritol pentaacrylate, di-trimethylolpropane tetraacrylate, etc.

The initiator or initiation system in the photosensitive elastomer layer may be benzophenone, Michler's ketone, 4-acetoxy 4'-diethylamine benzophenone, benzoin ethyl ether, α-hydroxyisopropylbenzophenone, α-hydroxycyclohexyl benzophenone, 2-phenyl-2,2-dimethoxyacetophenone, 2-tert-butyl anthraquinone, isopropylthioxanthone, (morpholinobenzoyl) 1-hexayl 1,1 (dimethylamino)propane, benzil, benzoin, UV6501 and UV6502 from Changsha Xinyu Polymer Technology Co., LTD, GR-TPO, GR-L1/1, GR-ITX, GR-XBPO, GR-TPO-L, and GE-DETX from Hubei Gurun Technology Co., LTD, Irgacure^{®} from foreign corporation of Ciba-Geigy, Omnirad^{®} from IGM, etc.

Other auxiliary agents such as an antioxidant, a thermal inhibitor, a release agent, a leveling agent, a dye, etc., may further be added into the photosensitive elastomer layer.

The bonding layer of the present invention may be polyurethane, polyurethane containing a 1,2-vinyl group in a side chain, polyester, a dichloroethylene copolymer, a vinylidene chloride-methacrylate-acrylic acid copolymer, an acrylic resin, a styrene-acrylate copolymer, or a mixture thereof. The components are formulated into a solution and coated onto the supporter of the present invention at a coating thickness of 1-10 µm, preferably 1-5 µm.

The supporter of the present invention may be polyhexylene naphthalene-2,6-dicarbonate, polyethylene terephthalate (PET), polybutylene terephthalate (PBT), a PP film, a PVC film, an aluminum plate base, a steel plate base, a magnetic steel base, etc., preferably a PET film with a thickness of 75-200 µm, preferably 100-175 µm.

Each component in the photosensitive elastomer layer is added into an extruder at a ratio, the mixture is heated, mixed, vented, etc., mixed at 110-150°C for 2-5 minutes, extruded, and prepared as a sheet with a thickness of 0.5-6.35 mm through a die, as the photosensitive elastomer layer, then the lower surface of the photosensitive elastomer sheet is heated, and pressurized and covered with a support film composed of the supporter and the bonding layer of the present invention, and at the same time the upper surface of the sheet of the photosensitive elastomer layer is heated, and pressurized and covered with a composite film containing the protective film, the laser-ablated black film layer, the oxygen blocking layer, and the rough surface layer with particles of the present invention, so as to obtain the flat-top dot flexographic resin plate with a texture on the surface thereof of the present invention.

A plate-making method for a flat-top dot flexographic resin plate with a texture on the surface thereof includes: back-exposing a plate to form a base; laser-engraving and ablating a black film layer (2); front-exposing by UV-A or UV-LED ultraviolet light; plate washing; drying by heating; post-exposing; and detackifying.

A specific plate-making process may be as follows: one side of a supporter is back-exposed by UV-A or UV-LED to form a base. Then the flexographic resin plate is turned over, the protective film is removed, the black film layer is ablated by an ND:YAG laser of 1,064-1,070 nm, etc., or laser-ablated by gasification to form an in-situ pattern, which is remained on the photosensitive elastomer layer, the laser-ablated portion may be transmitted by ultraviolet light, and the non-ablated portion may form a mask to block the transmitting of the ultraviolet light. Then the front surface is exposed by UV-A or UV-LED, in the laser-ablated portion, the ultraviolet light transmitted through to enable the cross-linking polymerization of a photosensitive elastomer, the laser non-ablated portion forms a mask which cannot be transmitted through by the ultraviolet light, and on this portion, the photosensitive elastomer cannot be subjected to the cross-linking polymerization, then the plate is developed in an organic solvent of tetrachloroethylene/n-butyl alcohol or an environmentally friendly developer containing terpene or a commercially available high-end environmentally friendly developer, etc., from Shanghai Minchen Corporation, the non-ablated laser-ablating layer portion and the uncrosslinked photosensitive elastomer are removed to form a raised pattern, and then the plate is dried at 60-70°C for 1.5-2 hours, post-exposed and detackified to obtain the flat-top dot flexographic resin plate with a texture on the surface thereof capable of being subjected to machine printing.

The beneficial effect of the present invention is as follows: compared with the prior art, the present invention provides a flat-top dot flexographic resin plate with a texture on the surface thereof and a plate-making method therefor, such that on the surface of the plate material, a texture may be formed and flat-top dots may be formed. Compared with the "bullet head" dots of a traditional digital flexographic resin plate, the texture on the surface of the plate material of the present invention may increase the printing ink transfer on the surface of the plate material, and improve the solid plate and dot ink transfer capability of the plate material, resulting in a higher ink density on a printing stock transferred from the surface of the printing plate and a higher color quality. The flat-top dots formed on the plate material of the present invention are in contact with an anilox roller, and are more wear-resistant, such that the press run of the plate material is improved.

### Brief Description of the Drawings

Fig. 1 is a perspective view and a profile view of 150 Ipi 2% dots of the flexographic resin plate obtained in example 1, wherein a is a front top view of 150 Ipi 2% dots, b is a side perspective view of 150 Ipi 2% dots, and c is a profile view of 150 lpi 2% dots.
Fig. 2 is a surface texture diagram of a solid plate portion of the flexographic resin plate obtained in example 1, with the surface of the solid plate having a clear texture.
Fig. 3 is a perspective view and a profile view of 150 Ipi 2% dots of the flexographic resin plate obtained in example 2, wherein a is a front top view of 150 Ipi 2% dots, b is a side perspective view of 150 Ipi 2% dots, and c is a profile view of 150 lpi 2% dots.
Fig. 4 is a surface texture diagram of a solid plate portion of the flexographic resin plate obtained in example 2, with the surface of the solid plate having a clear texture.
Fig. 5 is a perspective view and a profile view of 150 Ipi 2% dots of the flexographic resin plate obtained in example 3, wherein a is a front top view of 150 Ipi 2% dots, b is a side perspective view of 150 Ipi 2% dots, and c is a profile view of 150 lpi 2% dots.
Fig. 6 is a surface texture diagram of a solid plate portion of the flexographic resin plate obtained in example 3, and a surface of the solid plate has a clear texture.
Fig. 7 is a perspective view and a profile view of 150 Ipi 2% dots of the flexographic resin plate obtained in comparative example 1, wherein a is a front top view of 150 Ipi 2% dots, b is a side perspective view of 150 Ipi 2% dots, and c is a profile view of 150 lpi 2% dots.
Fig. 8 is a solid plate portion of the flexographic resin plate obtained in comparative example 1, with the surface of the solid plate being free of texture.
Fig. 9 is a perspective view and a profile view of 150 Ipi 2% dots of the flexographic resin plate obtained in comparative example 2, wherein a is a front top view of 150 Ipi 2% dots, b is a side perspective view of 150 Ipi 2% dots, and c is a profile view of 150 lpi 2% dots.
Fig. 10 is a solid plate portion of the flexographic resin plate obtained in comparative example 2, with the surface of the solid plate being free of texture.
Fig. 11 is a perspective view and a profile view of 150 Ipi 2% dots of the flexographic resin plate obtained in comparative example 3, wherein a is a front top view of 150 Ipi 2% dots, b is a side perspective view of 150 Ipi 2% dots, and c is a profile view of 150 lpi 2% dots.
Fig. 12 is a surface texture diagram of a solid plate portion of the flexographic resin plate obtained in comparative example 3, with the surface of the solid plate having a clear texture.
Fig. 13 is a perspective view and a profile view of 150 Ipi 2% dots of the flexographic resin plate obtained in comparative example 4, wherein a is a front top view of 150 Ipi 2% dots, b is a side perspective view of 150 Ipi 2% dots, and c is a profile view of 150 lpi 2% dots.
Fig. 14 is a solid plate portion of the flexographic resin plate obtained in comparative example 4, with the surface of the solid plate being free of texture.

### Detailed Description of Embodiments

The present disclosure will be specifically described in conjunction with specific examples. It should be understood that the examples are presented only for further illustrating the present disclosure and not intended to limit the scope of protection of the present disclosure. A person skilled in the art can make some non-essential improvements and adjustments according to the content of the present disclosure.

### I. The organic particles and the dispersion systems thereof used in the present invention are synthesized as follows:

### Synthesis example 1. Synthesis of polymethyl methacrylate-water dispersion system

A 3 mass % aqueous sodium dodecyl sulfate solution is prepared, and 48 g of refined azobisisobutyronitrile is weighed and dissolved in 2000 ml of methyl methacrylate for later use.

In a 100 L dispersion kettle, 20 L of deionized water is firstly added, stirring is started, the water is heated to an internal temperature of 60°C, and 800 ml of the 3 mass % aqueous sodium dodecyl sulfate solution is added. Then the pre-dissolved methyl methacrylate-azobisisobutyronitrile solution and 24 ml of a 0.5 mass % m-benzene solution are added. The materials are dispersed and stirred for 30 minutes, and then the stirring is stopped.

The dispersed materials are distributed into a 50 L stainless steel barrel, the barrel is capped and then immediately placed into a constant-temperature water tank at 60°C ± 1°C for polymerization with the temperature maintained for 20 hours.

The polymer is removed from the constant-temperature water tank, the supernatant clean water is poured out, and then 8 L of deionized water is added. After having been stirred uniformly, the polymer material is filtered with a nylon cloth and placed in a 50 L stainless steel barrel, 30 L of deionized water is added, the mixture is stirred uniformly and left to stand for 24 hours, the supernatant liquid is poured out, and a white solid participated at the bottom of the barrel, namely a finished product of polymethyl methacrylate particles. 1.15 kg of the product is obtained with an average particle size of 6.6 microns.

1.15 kg of the foregoing methyl methacrylate particles are added into 18 kg of water, stirring is started, 9 kg of a 4 mass % aqueous 8811 solution is added, 130 mm of a mixed antifoaming agent composed of hexadecanol and n-butyl alcohol at a mass ratio of 1 : 3 is added, followed by stirring for 2 hours and material discharge to obtain the polymethyl methacrylate-water dispersion system for later use. The structure of the 8811 surfactant is sodium diisooctyl succinate.

### Synthesis example2: Polymethacrylate-gelatin dispersion system

A3 mass % aqueous sodium dodecyl sulfate solution is prepared, and 48 g of refined benzoyl peroxide is weighed and dissolved in 2000 ml of methyl methacrylate for later use.

In a 100 L dispersion kettle, 20 L of deionized water is firstly added, stirring is started, the water is heated to an internal temperature of 60°C, and 800 ml of the 3 mass % aqueous sodium dodecyl sulfate solution is added. Then the pre-dissolved methyl methacrylate-benzoyl peroxide solution and 24 ml of a 0.5 mass % m-benzene solution are added. The materials are dispersed and stirred for 30 minutes, and then the stirring is stopped.

The dispersed materials are distributed into a 50 L stainless steel barrel, the barrel is capped and then immediately placed into a constant-temperature water tank at 54°C ± 1°C for polymerization with the temperature maintained for 20 hours.

The polymer is removed from the constant-temperature water tank, the supernatant clean water is poured out, and then 8 L of deionized water is added. After having been stirred uniformly, the polymer material is filtered with a nylon cloth and placed in a 50 L stainless steel barrel, 30 L of deionized water is added, the mixture is stirred uniformly and left to stand for 24 hours, the supernatant liquid is poured out, and a white solid participated at the bottom of the barrel, namely a finished product of polymethyl methacrylate particles. 1.2 kg of the product is obtained with an average particle size of 7.8 microns.

8 kg of a 4.8 mass % gelatin aqueous solution and 8 kg of a 4 mass % sodium chloride aqueous solution are added into 1.2 kg of the methyl methacrylate particles, the stirring is started, 135 mm of a mixed antifoaming agent composed of hexadecanol and n-butyl alcohol at a mass ratio of 1 : 3 is added, followed by stirring for 2 hours and material discharge to obtain the polymethyl methacrylate-gelatin dispersion system for later use.

### Synthesis example 3: Polymethacrylate-polyvinyl alcohol dispersion system

A3 mass % aqueous sodium dodecyl sulfate solution is prepared, and 60 g of refined benzoyl peroxide is weighed and dissolved in 2000 ml of methyl methacrylate for later use.

In a 100 L dispersion kettle, 20 L of deionized water is firstly added, stirring is started, the water is heated to an internal temperature of 60°C, and 800 ml of the 3 mass % aqueous sodium dodecyl sulfate solution is added. Then the pre-dissolved methyl methacrylate-benzoyl peroxide solution and 35 ml of a 0.5 mass % m-benzene solution are added. The materials are dispersed and stirred for 30 minutes, and then the stirring is stopped.

The dispersed materials are distributed into a 50 L stainless steel barrel, the barrel is capped and then immediately placed into a constant-temperature water tank at 57°C ± 1°C for polymerization with the temperature maintained for 20 hours.

The polymer is removed from the constant-temperature water tank, the supernatant clean water is poured out, and then 8 L of deionized water is added. After having been stirred uniformly, the polymer material is filtered with a nylon cloth and placed in a 50 L stainless steel barrel, 30 L of deionized water is added, the mixture is stirred uniformly and left to stand for 24 hours, the supernatant liquid is poured out, and a white solid participated at the bottom of the barrel, namely a finished product of polymethyl methacrylate particles. 1.05 kg of the product is obtained with an average particle size of 4.8 microns.

1.05 kg of the methyl methacrylate particles are added into 16 kg of a 5.1 mass % PVA aqueous solution, stirring is started, 120 mm of a mixed antifoaming agent composed of hexadecanol and n-butyl alcohol at a mass ratio of 1 : 3 is added, followed by stirring for 2 hours and material discharge to obtain the polymethyl methacrylate-polyvinyl alcohol dispersion system for later use.

### II. Specific examples of the flat-top dot flexographic resin plate with a texture on the surface thereof are as follows:

### Example 1

The protective film is made of polyethylene terephthalate (PET) with a thickness of 100 µm, and produced by the Lucky corporation. The protective film may also be made of polyhexylene naphthalene-2,6-dicarbonate, polybutylene terephthalate, etc., with a thickness of 50-150 µm.

The laser-ablated layer is prepared according to example 1 of ZL201110437989.9.

Preparation of oxygen blocking layer: 4.2 g of polyamide of Macromelt^{®}6900 (produced by Henkel corporation, Germany), 0.6 g of AS-586 (35 : 45 : 20 wt% of acrylamide-styrene-methyl methacrylate, Lucky Chemical Co., LTD), and 0.2 g of a halogen-free flame retardant of DAIGUARD-880 (produced by Japan Daihachi corporation) are dissolved in 95 g of a solvent of benzyl alcohol and n-butyl alcohol at a mass ratio of 30 : 70, and the solution is coated onto the laser-ablated layer at a speed of 30 m/min and dried at 70°C for 10 minutes to obtain a bonding layer with a coating thickness of 2.6 µm and an oxygen blocking layer with a coating dry weight of 2.51 g/m².

The polymethyl methacrylate-water dispersion system of synthesis example 1 is sprayed on the oxygen blocking layer with a diaphragm pump at an outlet pressure of 2 kg, and dried at 120°C for 2 minutes to obtain a rough surface layer with particles.

The protective film, the laser-ablated layer, the oxygen blocking layer, and the rough surface layer with particles constitute a composite film for later use.

Preparation of photosensitive elastomer layer: 700 g of a thermoplastic elastomer of SIS1107 (Kraton corporation), 100 g of a plasticizer of polybutadiene NissoPB-P2000 (Nippon Soda, Japan), 100 g of Drakeol^{®}34MIN OIL (CLUMENT, USA), 32 g of 1-hydroxycyclohexyl phenyl ketone (Zhangjiagang Free Trade Zone Tianjie International Trade Co., LTD), 12 g of 2,6-ditert-butyl-p-cresol (Nanjing Jiulong Chemical Co., LTD), 40 g of trimethylolpropane triacrylate (Tianjin Tianjiao Chemical Co., LTD), 15.8 g of 1,9-nonanediol diacrylate (Tianjin Tianjiao Chemical Co., LTD), and 0.2 g of a dye of RED 335 (BASF corporation) are added to a twin-screw extruder, and mixed at 150°C for 2 minutes to extrude a photosensitive elastomer layer with a thickness of 1.585 mm for later use.

Preparation of bonding layer: 100 g of methyl ethyl ketone, 50 g of butyl acetate, 40 g of polyurethane vinyl acetate of R-317 (produced by Lucky corporation), then 2 g of trimethylolpropane triacrylate (TMPTA, Tianjin Tianjiao Chemical Co., LTD), 0.5 g of an initiator of 1-hydroxycyclohexyl phenyl ketone (commonly known as 184, Zhangjiagang Free Trade Zone Tianjie International Trade Co., LTD), 0.2 g of 2,6-ditert-butyl-p-cresol (commonly known as 264, Nanjing Jiulong Chemical Co., LTD), and 0.05 g of FC-4430 (produced by 3M corporation) are added, the mixture is stirred in a closed container under a yellow safety light for 2 hours to obtain a coating solution of a cross-linked layer, the solution is coated onto a supporter at a speed of 30 m/min and dried at 60°C for 10 minutes to obtain a bonding layer with a coating thickness of 2.9 µm and a coating dry weight of 2.86 g/m², and a support film is prepared and rolled for later use.

The supporter is made of polyethylene terephthalate with a thickness of 125 µm, and produced by the Lucky corporation. The supporter may also be made of polyhexylene naphthalene-2,6-dicarbonate, polyethylene terephthalate, etc., with a thickness of 50-300 µm.

The bonding layer and the supporter constitute the support film for later use.

A lower surface of a sheet of the photosensitive elastomer layer extruded in the example with a thickness of 1.585 mm is coated with the support film composed of the bonding layer and the supporter under heating and pressurization of 120°C and 6 MPa. At the same time, an upper surface of the sheet of the photosensitive elastomer layer is coated with the composite film composed of the protective film, the laser-ablated layer, the oxygen blocking layer, and the rough surface layer with particles in the present example under heating and pressurization of 120°C and 6 MPa, so as to obtain a flat-top dot flexographic resin plate with a texture on the surface thereof.

The protective film of the printing plate prepared in the present invention is not removed, the plate is firstly back-exposed for 22 seconds by a UV-A exposure lamp (with a light intensity of 18.1 mw/cm2 at 365 nm), then the protective film is removed, and the flexographic resin plate of the present invention is fed to a CDI SPARK 2120 plate-making machine (manufactured by ESKO corporation) at 2540 dpi with an imaging speed set to be Optics10.0 and a main laser wavelength of 1,071 nm to ablate the laser-ablated layer black film 2. The ablated pattern contains 1%, 2%, 3%, 4%, 5%, 10%, 20%, 30%, 40%, 50%, 60%, 70%, 80%, 90%, 95%, 96%, 97%, 98%, and 100% dots at 150 lpi, solid plates, 0.08 mm, 0.10 mm, 0.15 mm, 0.20 mm, and 0.30 mm of independent positive and negative lines, and 0.08 mm, 0.10 mm, 0.15 mm, 0.20 mm, and 0.30 mm of independent dots and independent negative lines. After the laser ablation, the morphology of the oxygen blocking layer is observed with a 3D microscope.

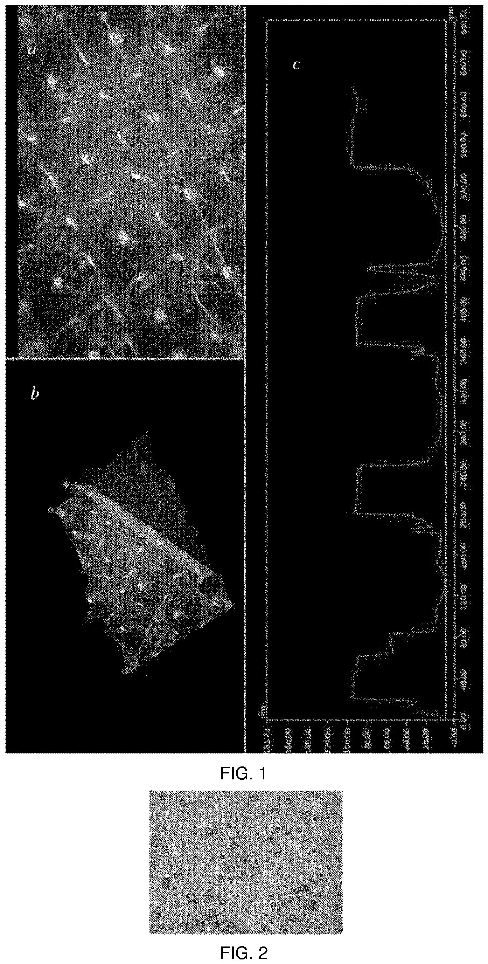

Then the plate material is front-exposed for 600 seconds by the UV-A exposure lamp (with a light intensity of 18.1 mw/cm2 at 365 nm), washed by a high-end environmentally friendly developer from Shanghai Minchen for 7 minutes, dried by hot air at 65°C for 2 hours, detackified for 5-12 minutes, and then post-exposed for 5 minutes. A 3D microscope, Vipflex334 and other devices are used for evaluation for the texture on the surface of the solid plate, the reproduction size of 2% dots, shapes of dot edges, being flat-top dots or not. The specific results are shown in Fig. 1 and Fig. 2. Fig. 1 is a perspective view and a profile view of 150 Ipi 2% dots of the flexographic resin plate obtained in example 1. Fig. 1a is a front top view of 150 Ipi 2% dots, Fig. 1b is a side perspective view of 150 Ipi 2% dots, and Fig. 1c is a profile view of 150 lpi 2% dots. From the profile view of the dots, it can be seen that the top of the dot is flat. Fig. 2 is a surface texture diagram of a solid plate portion of the flexographic resin plate obtained in example 1, with the surface of the solid plate having a clear texture.

### Example 2

The protective film may also be made of polyhexylene naphthalene-2,6-dicarbonate, polyethylene terephthalate (PET), polybutylene terephthalate (PBT), etc., with a thickness of 50-150 µm. In the present example, PET is used as a protective film with a thickness of 125 µm and manufactured by the Lucky corporation.

The laser-ablated layer is prepared according to example 2 of ZL201110437989.9.

Preparation of oxygen blocking layer: 4.5 g of polyamide of Macromelt^{®} 6900 (produced by Henkel corporation, Germany), 0.5 g of AS-588 (30 : 45 : 25 wt% of N-hydroxyethyl acrylamide-styrene-methyl methacrylate, Lucky Chemical Co., LTD), and 0.3 g of a halogen-free flame retardant of DAIGUARD-880 (produced by Japan Daihachi corporation) are dissolved in 100 g of a solvent of benzyl alcohol and n-butyl alcohol at a mass ratio of 30 : 70, and the solution is coated onto the laser-ablated layer at a speed of 30 m/min and dried at 70°C for 10 minutes to obtain a bonding layer with a coating thickness of 2.7 µm and an oxygen blocking layer with a coating dry weight of 2.65 g/m².

The polymethacrylate-gelatin dispersion system of synthesis example 2 is sprayed on the oxygen blocking layer with a diaphragm pump at an outlet pressure of 3.1 kg, and dried at 120°C for 2 minutes to obtain a rough surface layer with particles.

The protective film, the laser-ablated layer, the oxygen blocking layer, and the rough surface layer with particles constitute a composite film for later use.

Preparation of photosensitive elastomer layer: 700 g of a thermoplastic elastomer SIS1107 (Kraton corporation), 100 g of a plasticizer of polybutadiene Nisso PB-P2000 (Nippon Soda, Japan), 100 g of Drakeol^{®}34MIN OIL (CLUMENT, USA), 32 g of 1-hydroxycyclohexyl phenyl ketone (Zhangjiagang Free Trade Zone Tianjie International Trade Co., LTD), 12 g of 2,6-ditert-butyl-p-cresol (Nanjing Jiulong Chemical Co., LTD), 40 g of trimethylolpropane triacrylate (Tianjin Tianjiao Chemical Co., LTD), 15.8 g of 1,9-nonanediol diacrylate (Tianjin Tianjiao Chemical Co., LTD), and 0.2 g of a dye of RED 335 (BASF corporation) are added to a twin-screw extruder, and mixed at 150°C for 2 minutes to extrude a photosensitive elastomer layer with a thickness of 0.970 mm for later use.

Preparation of bonding layer: 100 g of methyl ethyl ketone, 50 g of butyl acetate, 40 g of polyurethane vinyl acetate of R-317 (produced by Lucky corporation), then 2 g of trimethylolpropane triacrylate (TMPTA, Tianjin Tianjiao Chemical Co., LTD), 0.5 g of an initiator of 1-hydroxycyclohexyl phenyl ketone (commonly known as 184, Zhangjiagang Free Trade Zone Tianjie International Trade Co., LTD), 0.2 g of 2,6-ditert-butyl-p-cresol (commonly known as 264, Nanjing Jiulong Chemical Co., LTD), and 0.05 g of FC-4430 (produced by 3M corporation) are added, the mixture is stirred in a closed container under a yellow safety light for 2 hours to obtain a coating solution of a cross-linked layer, the solution is coated onto a supporter at a speed of 30 m/min and dried at 60°C for 10 minutes to obtain a bonding layer with a coating thickness of 2.9 µm and a coating dry weight of 2.86 g/m², and a support film is prepared and rolled for later use.

The supporter may also be made of polyhexylene naphthalene-2,6-dicarbonate, polyethylene terephthalate, polybutylene terephthalate, etc., with a thickness of 50-300 µm. In this example, the polyethylene terephthalate (produced by Lucky corporation) with a thickness of 175 µm (transmittance of 365 nm UV of 10 ± 2%) is used as a supporter.

The bonding layer and the supporter constitute the support film for later use.

A lower surface of a sheet of the photosensitive elastomer layer extruded in the example with a thickness of 0.970mm is coated with the support film composed of the bonding layer and the supporter under heating and pressurization of 120°C and 6 MPa. At the same time, an upper surface of the sheet of the photosensitive elastomer layer is coated with the composite film composed of the protective film, the laser-ablated layer, the oxygen blocking layer, and the rough surface layer with particles in the present example under heating and pressurization of 120°C and 6 MPa, so as to obtain a flat-top dot flexographic resin plate with a texture on the surface thereof.

The protective film of the printing plate prepared in the present invention is not removed, the plate is firstly back-exposed for 45 seconds (with a light intensity of 18.1 mw/cm² at 365 nm), then the protective film is removed, and the flexographic resin plate of the present invention is fed to a CDI SPARK 2120 plate-making machine (manufactured by ESKO corporation) at 2540 dpi with an imaging speed set to be Optics 10.0 and a main laser wavelength of 1,071 nm to ablate the laser-ablated layer black film 2. The ablated pattern contains 1%, 2%, 3%, 4%, 5%, 10%, 20%, 30%, 40%, 50%, 60%, 70%, 80%, 90%, 95%, 96%, 97%, 98%, and 100% dots at 150 lpi, solid plates, 0.08 mm, 0.10 mm, 0.15 mm, 0.20 mm, and 0.30 mm of independent positive and negative lines, and 0.08 mm, 0.10 mm, 0.15 mm, 0.20 mm, and 0.30 mm of independent dots and independent negative lines. After the laser ablation, the morphology of the oxygen blocking layer is observed with a 3D microscope.

Then the plate material is front-exposed for 720 seconds by the UV-A exposure lamp (with a light intensity of 18.1 mw/cm2 at 365 nm), washed by a high-end environmentally friendly developer from Shanghai Minchen for 7 minutes, dried by hot air at 65°C for 2 hours, detackified for 5-12 minutes, and then post-exposed for 5 minutes. A 3D microscope, Vipflex334 and other devices are used for evaluation for the texture on the surface of the solid plate, the reproduction size of 2% dots, shapes of dot edges, being flat-top dots or not.

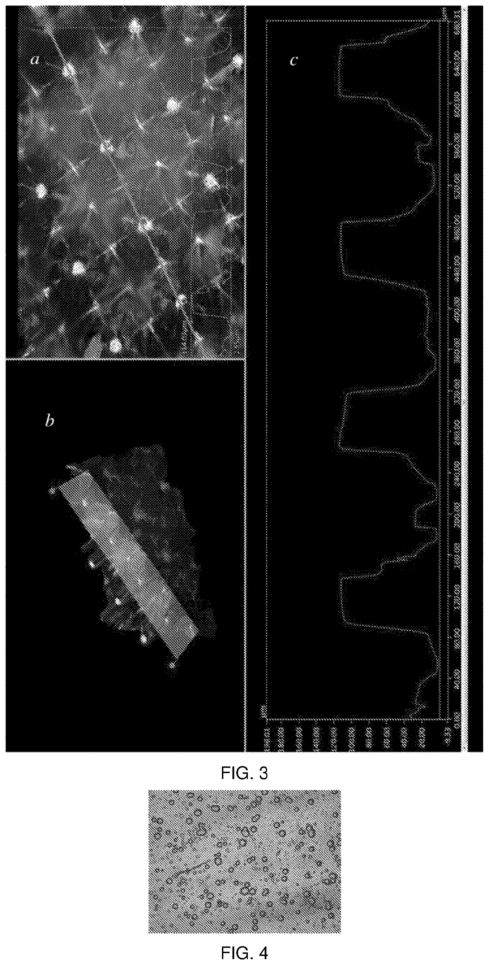

The specific results are shown in Fig. 3 and Fig. 4. Fig. 3 is a perspective view and a profile view of 150 Ipi 2% dots of the flexographic resin plate obtained in example 2. Fig. 3a is a front top view of 150 Ipi 2% dots, Fig. 3b is a side perspective view of 150 Ipi 2% dots, and Fig. 3c is a profile view of 150 lpi 2% dots. From the profile view of the dots, it can be seen that the top of the dot is flat. Fig. 4 is a surface texture diagram of a solid plate portion of the flexographic resin plate obtained in example 2, with the surface of the solid plate having a clear texture.

### Example 3

The protective film may also be made of polyhexylene naphthalene-2,6-dicarbonate, polyethylene terephthalate (PET), polybutylene terephthalate (PBT), etc., with a thickness of 50-150 µm. In the present example, PET is used as a protective film with a thickness of 125 µm and manufactured by the Lucky corporation.

The laser-ablated layer is prepared according to example 3 of ZL201110437989.9.

Preparation of oxygen blocking layer: 4.2 g of polyamide of Macromelt^{®} 6900 (produced by Henkel corporation, Germany), 0.6 g of AS-586 (35 : 45 : 20 wt% of acrylamide-styrene-methyl methacrylate, Lucky Chemical Co., LTD), and 0.2 g of a halogen-free flame retardant of DAIGUARD-880 (produced by Japan Daihachi corporation) are dissolved in 95 g of a solvent of benzyl alcohol and n-butyl alcohol at a mass ratio of 30 : 70, and the solution is coated onto the laser-ablated layer at a speed of 30 m/min and dried at 70°C for 10 minutes to obtain a bonding layer with a coating thickness of 2.6 µm and an oxygen blocking layer with a coating dry weight of 2.51 g/m².

The polymethacrylate-polyvinyl alcohol dispersion system of synthesis example 3 is sprayed on the oxygen blocking layer with a diaphragm pump at an outlet pressure of 2.6 kg, and dried at 120°C for 2 minutes to obtain a rough surface layer with particles.

The protective film, the laser-ablated layer, the oxygen blocking layer, and the rough surface layer with particles constitute a composite film for later use.

Preparation of photosensitive elastomer layer: 700 g of a thermoplastic elastomer SIS 1107 (Kraton corporation), 100 g of a plasticizer of polybutadiene Nisso PB-P2000 (Nippon Soda, Japan), 100 g of Drakeol^{®}34 MIN OIL (CLUMENT, USA), 32 g of 1-hydroxycyclohexyl phenyl ketone (Zhangjiagang Free Trade Zone Tianjie International Trade Co., LTD), 12 g of 2,6-ditert-butyl-p-cresol (Nanjing Jiulong Chemical Co., LTD), 40 g of trimethylolpropane triacrylate (Tianjin Tianjiao Chemical Co., LTD), 15.8 g of 1,9-nonanediol diacrylate (Tianjin Tianjiao Chemical Co., LTD), and 0.2 g of a dye of RED 335 (BASF corporation) are added to a twin-screw extruder, and mixed at 150°C for 2 minutes to extrude a photosensitive elastomer layer with a thickness of 2.720 mm for later use.

Preparation of bonding layer: 100 g of methyl ethyl ketone, 50 g of butyl acetate, 40 g of polyurethane vinyl acetate of R-317 (produced by Lucky corporation), then 2 g of trimethylolpropane triacrylate (TMPTA, Tianjin Tianjiao Chemical Co., LTD), 0.5 g of an initiator of 1-hydroxycyclohexyl phenyl ketone (commonly known as 184, Zhangjiagang Free Trade Zone Tianjie International Trade Co., LTD), 0.2 g of 2,6-ditert-butyl-p-cresol (commonly known as 264, Nanjing Jiulong Chemical Co., LTD), and 0.05 g of FC-4430 (produced by 3M corporation) are added, the mixture is stirred in a closed container under a yellow safety light for 2 hours to obtain a coating solution of a cross-linked layer, the solution is coated onto a supporter at a speed of 30 m/min and dried at 60°C for 10 minutes to obtain a bonding layer with a coating thickness of 2.9 µm and a coating dry weight of 2.86 g/m², and a support film is prepared and rolled for later use.

The supporter may also be made of polyhexylene naphthalene-2,6-dicarbonate, polyethylene terephthalate, polybutylene terephthalate, etc., with a thickness of 50-300 µm. In this example, the polyethylene terephthalate (produced by Lucky corporation) with a thickness of 125 µm is used as a supporter.

The bonding layer and the supporter constitute the support film for later use.

A lower surface of a sheet of the photosensitive elastomer layer extruded in the example with a thickness of 2.720 mm is coated with the support film composed of the bonding layer and the supporter under heating and pressurization of 120°C and 6 MPa. At the same time, an upper surface of the sheet of the photosensitive elastomer layer is coated with the composite film composed of the protective film, the laser-ablated layer, the oxygen blocking layer, and the rough surface layer with particles in the present example under heating and pressurization of 120°C and 6 MPa, so as to obtain a flat-top dot flexographic resin plate with a texture on the surface thereof.

The protective film of the printing plate prepared in the present invention is not removed, the plate is firstly back-exposed for 22 seconds (with a light intensity of 16.8 mw/cm2 at 365 nm), then the protective film is removed, and the flexographic resin plate of the present invention is fed to a CDI SPARK 2120 plate-making machine (manufactured by ESKO corporation) at 2540 dpi with an imaging speed set to be Optics 10.0 and a main laser wavelength of 1,071 nm to ablate the laser-ablated layer black film 2. The ablated pattern contains 1%, 2%, 3%, 4%, 5%, 10%, 20%, 30%, 40%, 50%, 60%, 70%, 80%, 90%, 95%, 96%, 97%, 98%, and 100% dots at 150 lpi, solid plates, 0.08 mm, 0.10 mm, 0.15 mm, 0.20 mm, and 0.30 mm of independent positive and negative lines, and 0.08 mm, 0.10 mm, 0.15 mm, 0.20 mm, and 0.30 mm of independent dots and independent negative lines. After the laser ablation, the morphology of the oxygen blocking layer is observed with a 3D microscope.

Then the plate material is front-exposed for 720 seconds by the UV-A exposure lamp (with a light intensity of 18.1 mw/cm2 at 365 nm), washed by a high-end environmentally friendly developer from Shanghai Minchen for 7 minutes, dried by hot air at 65°C for 2 hours, detackified for 5-12 minutes, and then post-exposed for 5 minutes. A 3D microscope, Vipflex334 and other devices are used for evaluation for the texture on the surface of the solid plate, the reproduction size of 2% dots, shapes of dot edges, being flat-top dots or not.

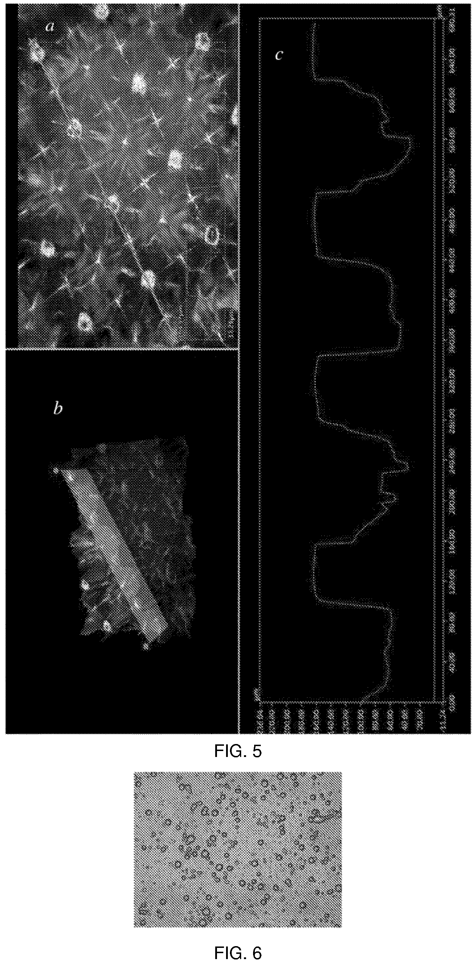

The specific results are shown in Fig. 5 and Fig. 6. Fig. 5 is a perspective view and a profile view of 150 Ipi 2% dots of the flexographic resin plate obtained in example 3. Fig. 5a is a front top view of 150 Ipi 2% dots, Fig. 5b is a side perspective view of 150 Ipi 2% dots, and Fig. 5c is a profile view of 150 lpi 2% dots. From the profile view of the dots, it can be seen that the top of the dots is flat. Fig. 6 is a surface texture diagram of a solid plate portion of the flexographic resin plate obtained in example 3, with the surface of the solid plate having a clear texture.

### Comparative example 1

The protective film is the same as that in Example 1.

The laser-ablated layer is prepared according to example 1 of ZL201110437989.9.

Preparation of oxygen blocking layer without halogen-free flame retardant: 4.2 g of polyamide of Macromelt^{®} 6900 (produced by Henkel corporation, Germany), and 0.6 g of AS-586 (35 : 45 : 20 wt% of acrylamide-styrene-methyl methacrylate, Lucky Chemical Co., LTD) are dissolved in 95 g of a solvent of benzyl alcohol and n-butyl alcohol at a mass ratio of 30 : 70, and the solution is coated onto the laser-ablated layer at a speed of 30 m/min and dried at 70°C for 10 minutes to obtain a bonding layer with a coating thickness of 2.6 µm and an oxygen blocking layer with a coating dry weight of 2.51 g/m2.

No rough surface layer with particles is arranged.

The protective film, the laser-ablated layer, and the oxygen blocking layer constitute a composite film for later use.

The preparation of the photosensitive elastomer layer is the same as that in Example 1.

The preparation of the bonding layer is the same as that in Example 1.

The supporter is the same as that in Example 1.

The bonding layer and the supporter constitute the support film for later use.

A lower surface of a sheet of the photosensitive elastomer layer extruded in the example with a thickness of 1.585 mm is coated with the support film composed of the bonding layer and the supporter under heating and pressurization of 120°C and 6 MPa. At the same time, an upper surface of the sheet of the photosensitive elastomer layer is coated with the composite film composed of the protective film, the laser-ablated layer, and the oxygen blocking layer in the present example under heating and pressurization of 120°C and 6 MPa, so as to obtain a digital flexographic resin plate.

The protective film of the printing plate prepared above is not removed, the plate is firstly back-exposed for 22 seconds (with a light intensity of 16.8 mw/cm2 at 365 m), then the protective film is removed, and the flexographic resin plate of the present invention is fed to a CDI SPARK 2120 plate-making machine (manufactured by ESKO corporation) at 2540 dpi with an imaging speed set to be Optics10.0 and a main laser wavelength of 1,071 nm to ablate the laser-ablated layer black film 2. The ablated pattern contains 1%, 2%, 3%, 4%, 5%, 10%, 20%, 30%, 40%, 50%, 60%, 70%, 80%, 90%, 95%, 96%, 97%, 98%, and 100% dots at 150 lpi, solid plates, 0.08 mm, 0.10 mm, 0.15 mm, 0.20 mm, and 0.30 mm of independent positive and negative lines, and 0.08 mm, 0.10 mm, 0.15 mm, 0.20 mm, and 0.30 mm of independent dots and independent negative lines. After the laser ablation, the morphology of the oxygen blocking layer is observed with a 3D microscope.

Then the plate material is front-exposed for 600 seconds by the UV-A exposure lamp (with a light intensity of 18.1 mw/cm² at 365 nm), washed by a high-end environmentally friendly developer from Shanghai Minchen for 7 minutes, dried by hot air at 65°C for 2 hours, detackified for 5-12 minutes, and then post-exposed for 5 minutes. A 3D microscope, Vipflex334 and other devices are used for evaluation for the texture on the surface of the solid plate, the reproduction size of 2% dots, shapes of dot edges, being flat-top dots or not.

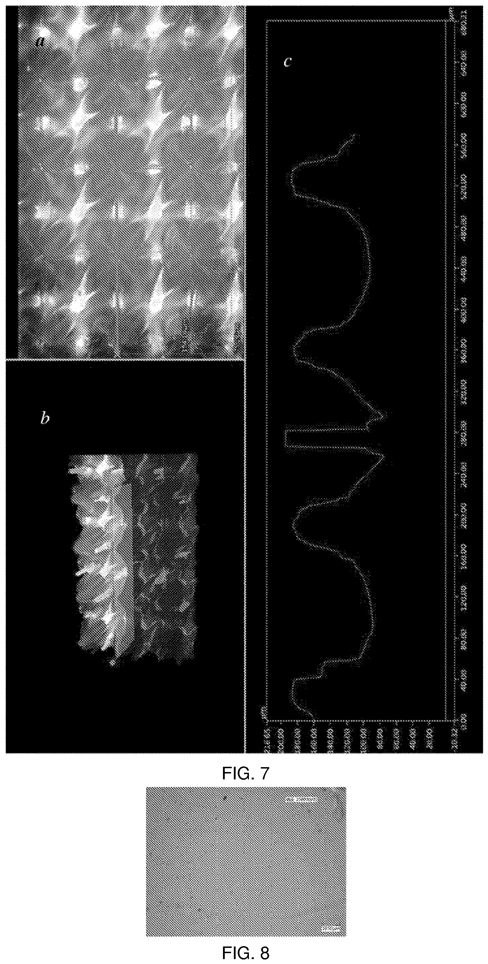

The specific results are shown in Fig. 7 and Fig. 8. Fig. 7 is a perspective view and a profile view of 150 Ipi 2% dots of the flexographic resin plate obtained in comparative example 1. Fig. 7a is a front top view of 150 Ipi 2% dots, Fig. 7b is a side perspective view of 150 Ipi 2% dots, and Fig. 7c is a profile view of 150 lpi 2% dots. From the profile view of the dots, it can be seen that the top of the dot is of a round tip shape, but not a flat top shape. Fig. 8 is a solid plate portion of the flexographic resin plate obtained in comparative example 1, with the surface of the solid plate being free of texture.

### Comparative example 2

The protective film is the same as that in Example 1.

The laser-ablated layer is prepared according to example 1 of ZL201110437989.9.

The preparation of the oxygen blocking layer is the same as that in Example 1.

No rough surface layer with particles is arranged.

The protective film, the laser-ablated layer, and the oxygen blocking layer constitute a composite film for later use.

The preparation of the photosensitive elastomer layer is the same as that in Example 1.

The preparation of the bonding layer is the same as that in Example 1.

The supporter is the same as that in Example 1.

The bonding layer and the supporter constitute the support film for later use.

A lower surface of a sheet of the photosensitive elastomer layer extruded in the example with a thickness of 1.585 mm is coated with the support film composed of the bonding layer and the supporter under heating and pressurization of 120°C and 6 MPa. At the same time, an upper surface of the sheet of the photosensitive elastomer layer is coated with the composite film composed of the protective film, the laser-ablated layer, and the oxygen blocking layer in the present example under heating and pressurization of 120°C and 6 MPa, so as to obtain a digital flexographic resin plate.

The protective film of the printing plate prepared above is not removed, the plate is firstly back-exposed for 22 seconds (with a light intensity of 16.8 mw/cm2 at 365 m), then the protective film is removed, and the flexographic resin plate of the present invention is fed to a CDI SPARK 2120 plate-making machine (manufactured by ESKO corporation) at 2540 dpi with an imaging speed set to be Optics10.0 and a main laser wavelength of 1,071 nm to ablate the laser-ablated layer black film 2. The ablated pattern contains 1%, 2%, 3%, 4%, 5%, 10%, 20%, 30%, 40%, 50%, 60%, 70%, 80%, 90%, 95%, 96%, 97%, 98%, and 100% dots at 150 lpi, solid plates, 0.08 mm, 0.10 mm, 0.15 mm, 0.20 mm, and 0.30 mm of independent positive and negative lines, and 0.08 mm, 0.10 mm, 0.15 mm, 0.20 mm, and 0.30 mm of independent dots and independent negative lines. After the laser ablation, the morphology of the oxygen blocking layer is observed with a 3D microscope.

Then the plate material is front-exposed for 600 seconds by the UV-A exposure lamp (with a light intensity of 18.1 mw/cm2 at 365 nm), washed by a high-end environmentally friendly developer from Shanghai Minchen for 7 minutes, dried by hot air at 65°C for 2 hours, detackified for 5-12 minutes, and then post-exposed for 5 minutes. A 3D microscope, Vipflex334 and other devices are used for evaluation for the texture on the surface of the solid plate, the reproduction size of 2% dots, shapes of dot edges, being flat-top dots or not.

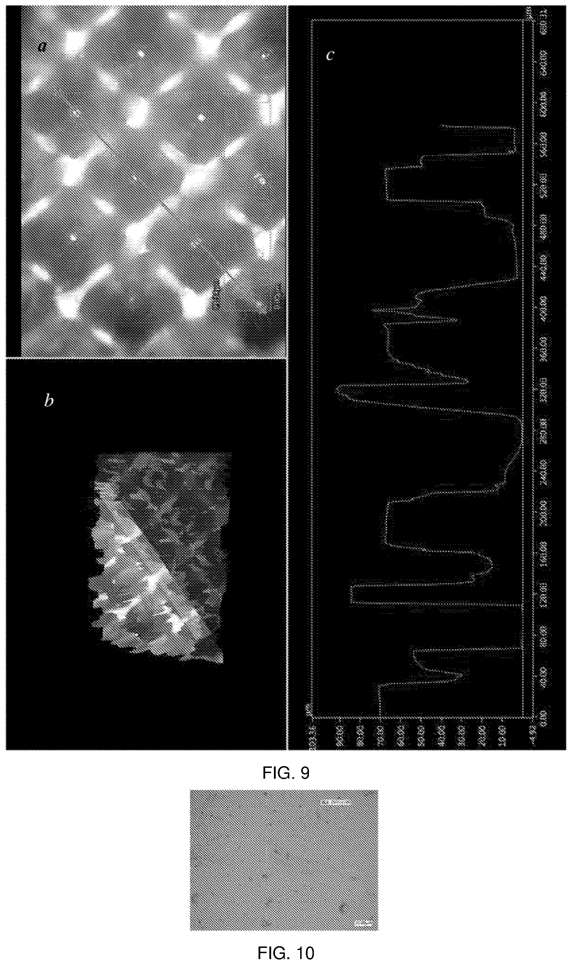

The specific results are shown in Fig. 9 and Fig. 10. Fig. 9 is a perspective view and a profile view of 150 Ipi 2% dots of the flexographic resin plate obtained in comparative example 2. Fig. 9a is a front top view of 150 Ipi 2% dots, Fig. 9b is a side perspective view of 150 Ipi 2% dots, and Fig. 9c is a profile view of 150 lpi 2% dots. From the profile view of the dots, it can be seen that the dots have a flat top, but a nonuniform size. Fig. 10 is a solid plate portion of the flexographic resin plate obtained in comparative example 2, with the surface of the solid plate being free of texture.

### Comparative example 3

The protective film is the same as that in Example 2.

The laser-ablated layer is prepared according to example 2 of ZL201110437989.9.

The preparation of an oxygen blocking layer is the same as that in Example 2 and no halogen-free flame retardant is contained.

The rough surface layer with particles is the same as that in Example 2.

The protective film, the laser-ablated layer, the oxygen blocking layer, and the rough surface layer with particles constitute a composite film for later use.

The preparation of the photosensitive elastomer layer is the same as that in Example 2.

The preparation of the bonding layer is the same as that in Example 2.

The supporter is the same as that in Example 2.

The bonding layer and the supporter constitute the support film for later use.

A lower surface of a sheet of the photosensitive elastomer layer extruded in the example with a thickness of 0.970 mm is coated with the support film composed of the bonding layer and the supporter under heating and pressurization of 120°C and 6 MPa. At the same time, an upper surface of the sheet of the photosensitive elastomer layer is coated with the composite film composed of the protective film, the laser-ablated layer, the oxygen blocking layer, and the rough surface layer with particles in the present example under heating and pressurization of 120°C and 6 MPa, so as to obtain a digital flexographic resin plate.

The protective film of the printing plate prepared above is not removed, the plate is firstly back-exposed for 45 seconds (with a light intensity of 18.1 mw/cm2 at 365 m), then the protective film is removed, and the flexographic resin plate of the present invention is fed to a CDI SPARK 2120 plate-making machine (manufactured by ESKO corporation) at 2540 dpi with an imaging speed set to be Optics10.0 and a main laser wavelength of 1,071 nm to ablate the laser-ablated layer black film 2. The ablated pattern contains 1%, 2%, 3%, 4%, 5%, 10%, 20%, 30%, 40%, 50%, 60%, 70%, 80%, 90%, 95%, 96%, 97%, 98%, and 100% dots at 150 lpi, solid plates, 0.08 mm, 0.10 mm, 0.15 mm, 0.20 mm, and 0.30 mm of independent positive and negative lines, and 0.08 mm, 0.10 mm, 0.15 mm, 0.20 mm, and 0.30 mm of independent dots and independent negative lines. After the laser ablation, the morphology of the oxygen blocking layer is observed with a 3D microscope.

Then the plate material is front-exposed for 720 seconds by the UV-A exposure lamp (with a light intensity of 18.1 mw/cm2 at 365 nm), washed by a high-end environmentally friendly developer from Shanghai Minchen for 7 minutes, dried by hot air at 65°C for 2 hours, detackified for 5-12 minutes, and then post-exposed for 5 minutes. A 3D microscope, Vipflex334 and other devices are used for evaluation for the texture on the surface of the solid plate, the reproduction size of 2% dots, shapes of dot edges, being flat-top dots or not.

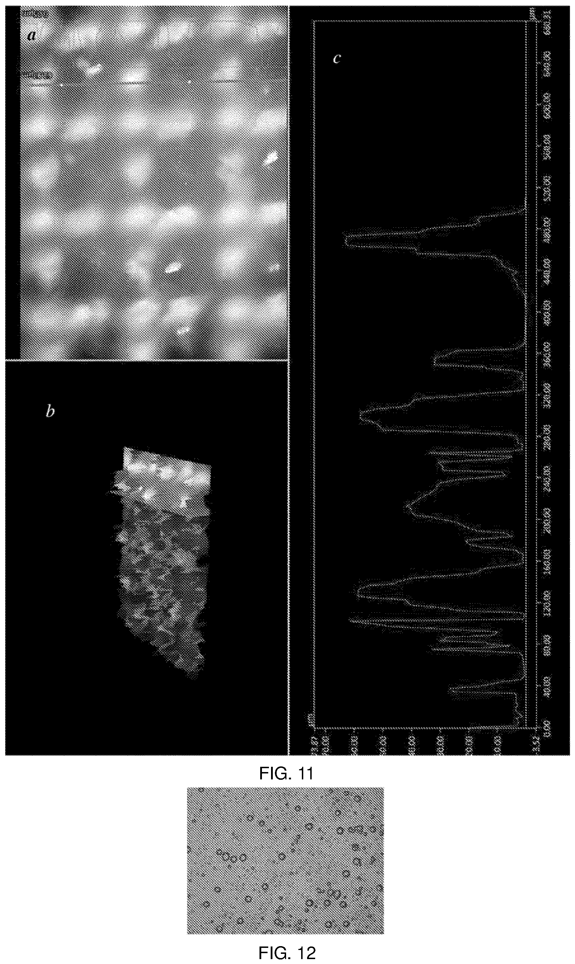

The specific results are shown in Fig. 11 and Fig. 12. Fig. 11 is a perspective view and a profile view of 150 Ipi 2% dots of the flexographic resin plate obtained in comparative example 3. Fig. 11a is a front top view of 150 Ipi 2% dots, Fig. 11b is a side perspective view of 150 Ipi 2% dots, and Fig. 11c is a profile view of 150 lpi 2% dots. From the profile view of the dots, it can be seen that the top of the dot is of a round tip shape, but not a flat top shape. Fig. 12 is a solid plate portion of the flexographic resin plate obtained in comparative example 3, with the surface of the solid plate having a clear texture.

### Comparative example 4

The protective film is the same as that in Example 2.

The laser-ablated layer is prepared according to example 2 of ZL201110437989.9.

The preparation of the oxygen blocking layer is the same as that in Example 2.

No rough surface layer with particles is arranged.

The protective film, the laser-ablated layer, and the oxygen blocking layer constitute a composite film for later use.

The preparation of the photosensitive elastomer layer is the same as that in Example 2.

The preparation of the bonding layer is the same as that in Example 2.

The supporter is the same as that in Example 2.

The bonding layer and the supporter constitute the support film for later use.

A lower surface of a sheet of the photosensitive elastomer layer extruded in the example with a thickness of 0.970 mm is coated with the support film composed of the bonding layer and the supporter under heating and pressurization of 120°C and 6 MPa. At the same time, an upper surface of the sheet of the photosensitive elastomer layer (5) is coated with the composite film composed of the protective film, the laser-ablated layer, and the oxygen blocking layer in the present example under heating and pressurization of 120°C and 6 MPa, so as to obtain a digital flexographic resin plate.

The protective film of the printing plate prepared above is not removed, the plate is firstly back-exposed for 45 seconds (with a light intensity of 18.1 mw/cm2 at 365 m), then the protective film is removed, and the flexographic resin plate of the present invention is fed to a CDI SPARK 2120 plate-making machine (manufactured by ESKO corporation) at 2540 dpi with an imaging speed set to be Optics10.0 and a main laser wavelength of 1,071 nm to ablate the laser-ablated layer black film 2. The ablated pattern contains 1%, 2%, 3%, 4%, 5%, 10%, 20%, 30%, 40%, 50%, 60%, 70%, 80%, 90%, 95%, 96%, 97%, 98%, and 100% dots at 150 lpi, solid plates, 0.08 mm, 0.10 mm, 0.15 mm, 0.20 mm, and 0.30 mm of independent positive and negative lines, and 0.08 mm, 0.10 mm, 0.15 mm, 0.20 mm, and 0.30 mm of independent dots and independent negative lines. After the laser ablation, the morphology of the oxygen blocking layer is observed with a 3D microscope.

Then the plate material is front-exposed for 720 seconds by the UV-A exposure lamp (with a light intensity of 18.1 mw/cm2 at 365 nm), washed by a high-end environmentally friendly developer from Shanghai Minchen for 7 minutes, dried by hot air at 65°C for 2 hours, detackified for 5-12 minutes, and then post-exposed for 5 minutes. A 3D microscope, Vipflex334 and other devices are used for evaluation for the texture on the surface of the solid plate, the reproduction size of 2% dots, shapes of dot edges, being flat-top dots or not.

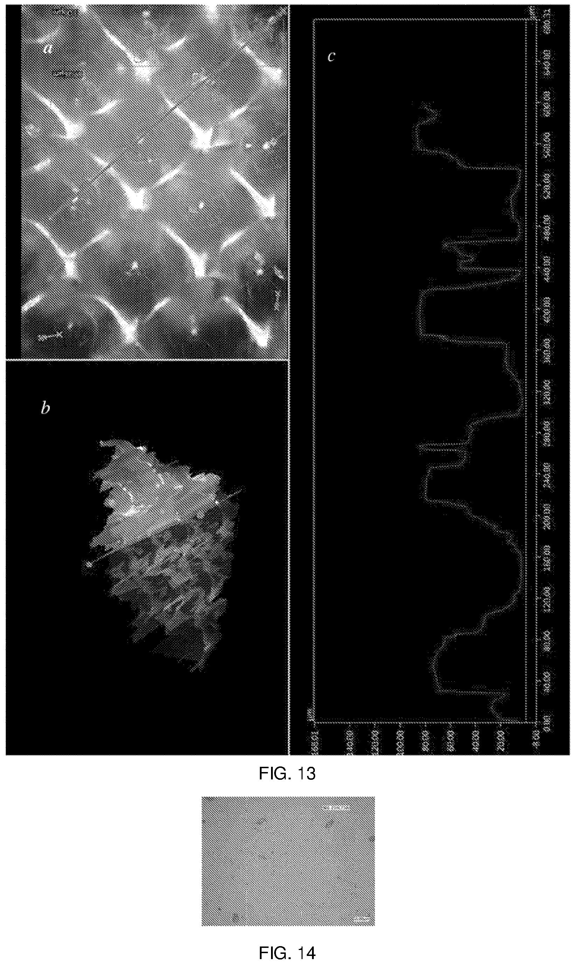

The specific results are shown in Fig. 13 and Fig. 14. Fig. 13 is a perspective view and a profile view of 150 Ipi 2% dots of the flexographic resin plate obtained in comparative example 4. Fig. 13a is a front top view of 150 Ipi 2% dots, Fig. 13b is a side perspective view of 150 Ipi 2% dots, and Fig. 13c is a profile view of 150 lpi 2% dots. From the profile view of the dots, it can be seen that the top of the dot is flat. Fig. 14 is a solid plate portion of the flexographic resin plate obtained in comparative example 4, with the surface of the solid plate being free of texture.

The evaluation results of examples 1-3 and comparative examples 1-4 are shown in Table 1.

**Table 1 Evaluation results of examples 1-3 and comparative examples 1-4**

| Experiment No. | Surface morphology of oxygen blocking layer after laser ablation of black film | Solid plate having a texture | Reproduction size of 150 Ipi 2% dots, % | 2% dots being flat-dots | 2% dot edge |
|---|---|---|---|---|---|
| Example 1 | Complete | Yes, see Fig. 2 | 1.6 | Yes, see Fig. 1 | Neat |
| Example 2 | Complete | Yes, see Fig. 4 | 1.5 | Yes, see Fig. 3 | Neat |
| Example 3 | Complete | Yes, see Fig. 6 | 1.8 | Yes, see Fig. 5 | Neat |
| Comparative example 1 | Not complete with cracks | No, see Fig. 8 | 0.3 | Are not, see Fig. 7 | A notch on the edge |
| Comparative example 2 | Complete | No, see Fig. 10 | 1.4 | Yes, see Fig. 9 | Basically neat and a part of tiny notches on the edge |
| Comparative example 3 | Not complete with cracks | Yes, see Fig. 12 | 0.4 | Are not, see Fig. 11 | A notch on the edge |
| Comparative example 4 | Complete | No, see Fig. 14 | 1.6 | Yes, see Fig. 13 | Neat |

As shown in Table 1, a flat-top dot flexographic resin plate with a texture on the surface thereof may be obtained by using the technology of the present invention.

The above examples are typical methods for preparing the flat-top dot flexographic resin plate with a texture on the surface thereof for better understanding of the present invention by readers, but the protection scope of the present invention is not limited thereto. It should be pointed out that for a person skilled in the art and a technician familiar with the art, without departing from the overall concept of the present invention, equivalent replacements or changes according to the technical solutions and the inventive concept of the present invention, and some changes and improvements should also be regarded as the protection scope of the present invention.

## Claims

1. A flat-top dot flexographic resin plate with a texture on the surface thereof, **characterized by**: comprising a laser-ablated black film layer, an oxygen blocking layer, a rough surface layer with particles, a photosensitive elastomer layer, a bonding layer, and a supporter from top to bottom; the particles in the rough surface layer are organic polymer particles with an average diameter of 0.5-15 µm; and when the rough surface layer with the organic polymer particles is laminated with the photosensitive elastomer layer, grains formed by the organic polymer particles are transferred to the surface of the photosensitive elastomer to form a texture.

2. The flat-top dot flexographic resin plate with a texture on the surface thereof according to claim 1, **characterized in that** the organic polymer particles in the rough surface layer are at least one of polymethyl methacrylate, polystyrene, polymethacrylate-gelatin dispersed particles, a vinylidene chloride-methyl methacrylate-acrylic acid polymer emulsion, a vinylidene chloride-styrene-methyl methacrylate-acrylic acid polymer emulsion, a styrene-acrylonitrile-methacrylate polyglycol ether copolymer, styrene-acrylonitrile-methacrylic acid polypropylene glycol ether ester copolymer particles, and polyvinyl chloride particles.

3. The flat-top dot flexographic resin plate with a texture on the surface thereof according to claim 2, **characterized in that** the organic polymer particles in the rough surface layer can be dispersed in water, a polyvinyl alcohol solution, an ethylene-vinyl acetate copolymer emulsion, a polyvinyl pyrrolidone solution, a gelatin solution, or an arabic gum solution.

4. The flat-top dot flexographic resin plate with a texture on the surface thereof according to claim 3, **characterized in that** the organic polymer particles in the rough surface layer has an average diameter of 0.5-10 µm; and a dispersion system of the organic polymer particles in the rough surface layer is at least one of a polymethyl methacrylate-water dispersion system, a polymethacrylate-gelatin dispersion system, and a polymethacrylate-polyvinyl alcohol dispersion system.

5. The flat-top dot flexographic resin plate with a texture on the surface thereof according to claim 1, **characterized in that** the organic polymer particles in the rough surface layer have an average diameter of 0.5-8 µm.

6. The flat-top dot flexographic resin plate with a texture on the surface thereof according to claim 1, **characterized in that** the organic polymer particles in the rough surface layer, in a hemispherical or oval shape, cover the surface of the oxygen blocking layer.

7. The flat-top dot flexographic resin plate with a texture on the surface thereof according to claim 1, **characterized in that** the oxygen blocking layer contains polyamide, an acrylic resin of acrylamide and a derivative thereof, a halogen-free flame retardant or a fire retardant.

8. The flat-top dot flexographic resin plate with a texture on the surface thereof according to claim 2, **characterized in that** the acrylic resin of acrylamide and a derivative thereof contained in the oxygen blocking layer is at least one of a poly(acrylamide-styrene-methyl methacrylate)resin, a poly(N-hydroxymethyl acrylamide-styrene-methyl methacrylate)resin, a poly(N-hydroxyethyl acrylamide-styrene-methyl methacrylate)resin or a poly(N-hydroxypropyl acrylamide-styrene-methyl methacrylate)resin; and the oxygen blocking layer has a thickness of 1-3 µm.

9. The flat-top dot flexographic resin plate with a texture on the surface thereof according to claim 1, **characterized in that** a protective film is arranged on the laser-ablated black film layer.

10. A plate-making method for a flat-top dot flexographic resin plate with a texture on the surface thereof according to any one of claims 1-9, **characterized by** comprising: back-exposing a plate to form a base; laser-engraving and ablating the black film layer; front-exposing by UV-A or UV-LED ultraviolet light; plate washing; drying by heating; post-exposing; and detackifying.
